# EUROPÄISCHE PATENTANMELDUNG

(11) **EP 4 016 108 A1**
(43) Veröffentlichungstag der Anmeldung: **22.06.2022**
(21) Anmeldenummer: 20214443.2
(22) Anmeldetag: 16.12.2020
(51) Int. Cl.: G01R 33/565, G01R 33/58

(54) **VERFAHREN ZUM ERZEUGEN EINER CHARAKTERISIERUNGSFUNKTION FÜR EIN GRADIENTENSYSTEM EINER MAGNETRESONANZANLAGE**

(71) Anmelder: Siemens Healthcare GmbH, 91052 Erlangen (DE); Julius-Maximilians-Universitaet Wuerzburg, 97070 Wuerzburg (DE)
(72) Erfinder: Scholten, Hannah, 97076 Würzburg (DE); Köstler, Herbert, 97225 Retzbach (DE); Stich, Manuel, 92711 Parkstein (DE)

(57) **Zusammenfassung**

Die Erfindung betrifft ein Verfahren zum Erzeugen einer Charakterisierungsfunktion (1) zwischen einem nominellen Magnetfeld und einem tatsächlichen Magnetfeld, welches durch ein Gradientensystem einer Magnetresonanzanlage (2) erzeugt wird, umfassend die Schritte: 1. Hintereinander Ausführen zumindest zweier Testmessungen (25, 26) an einem in der Magnetresonanzanlage (2) platzierten Objekt (7), wobei jede Testmessung (25, 26) die folgenden Schritte aufweist:(a) Erzeugen eines Anregungspulses (21); (b) Auslesen eines MR-Signals während eines vorbestimmten Aufnahmezeitfensters (22) nach dem Anregungspuls (21);(c) Erzeugen eines Testgradientenpulses (20) gemäß einem nominellen Testgradientenpuls (20), mit einem für jede Testmessung (25, 26) vorbestimmten zeitlichen Versatz (24) zwischen dem Zeitpunkt des Anregungspulses (21) und dem Zeitpunkt des Testgradientenpulses (20), wobei sich der zeitliche Versatz (24) zwischen dem Zeitpunkt des Anregungspulses (21) und dem Zeitpunkt des Testgradientenpulses (20) bei einer ersten Testmessung (25) von dem zeitlichen Versatz (24) bei einer zweiten Testmessung (26) unterscheidet; 2. Ermitteln des tatsächlichen Magnetfeldes des Testgradientenpulses (20) durch Zusammenfügen und Auswerten der mit den Testmessungen (25, 26) ausgelesenen MR-Signale; 3. Berechnen zumindest eines Terms der Charakterisierungsfunktion (1) durch Vergleich des nominellen Magnetfeldes des Testgradientenpulses (20) mit dem ermittelten tatsächlichen Magnetfeld.

## Beschreibung

Die Erfindung betrifft ein Verfahren zum Erzeugen bzw. Bestimmen einer Charakterisierungsfunktion für ein Gradientensystem einer Magnetresonanzanlage, eine Magnetresonanzanlage mit einem Magnetfeldgradientensystem und einen Datenträger mit einer entsprechenden Charakterisierungsfunktion.

Magnetische Gradientenfelder, d.h. linear ortsabhängige Magnetfelder, spielen eine Schlüsselrolle in der Magnetresonanztomographie (MRT), indem sie es, mittels Manipulation der von der magnetischen Flussdichte abhängigen Larmorfrequenz der Spins, ermöglichen, Magnetresonanzsignale (MR-Signale) ortszukodieren und somit räumlich aufgelöste Bilddaten zu akquirieren. Beispielsweise können drei separate Gradientenspulen verwendet werden, welche dazu konfiguriert sind, Gradientenfelder in drei senkrecht zueinanderstehenden Raumrichtungen erzeugen zu können. Um eine Ortskodierung in jeder beliebigen Raumrichtung zu ermöglichen, können die drei Gradientenspulen kombiniert werden, um durch Überlagerung ihrer Felder einen Gradienten in der gewünschten Richtung zu erzeugen. Folglich hängt die resultierende Bildqualität stark von der Genauigkeit der angelegten Gradientenfelder ab. In der Praxis weichen die tatsächlichen Magnetfelder allerdings typischerweise von den nominellen Gradientenfeldern, beispielsweise gemäß einer eingestellten Bildgebungssequenz, ab und führen damit zu einer Beeinträchtigung der Bildqualität. Die Abweichungen sind z.B. auf induzierte Wirbelströme, mechanische Schwingungen der magnetfelderzeugenden Spulen und/oder thermische Schwankungen zurückzuführen.

In dem Artikel von Vannesjo et al.: Gradient System Characterization by Impulse Response Measurements with a Dynamic Field Camera. Magn. Reson. Med. 2013; 69:583-593 wird die Möglichkeit beschrieben, eine Impulsantwort experimentell zu ermitteln, indem mittels mehrerer Kernspinresonanz-Sonden das tatsächliche Magnetfeld bestimmt und mit dem aufgrund von bekannten bzw. eingestellten Eingangssignalen der Gradienten erwarteten, d.h. nominellen, Magnetfeld verglichen wird. Die Impulsantwort beschreibt dabei den Unterschied zwischen dem nominellen und dem tatsächlichen Magnetfeld und kann verwendet werden, um diesen Unterschied auszugleichen. Für diese Methode wird jedoch zusätzliche Ausrüstung benötigt, um die Magnetfelder bestimmen zu können.

In dem Artikel Stich et al: Gradient waveform pre-emphasis based on the gradient system transfer function. Magn. Reson. Med. 2018; 80:1521-1532 ist eine Möglichkeit beschrieben, Änderungen im Magnetfeld über das Ausmessen des MR-Signals eines kugelförmigen Phantoms zu bestimmen. Dabei wird das Phantom zunächst mittels eines Hochfrequenzpulses (HF-Pulses) angeregt und daraufhin wird durch das Gradientensystem ein Gradientenpuls in Form eines Dreiecksignals erzeugt. Das durch den HF-Puls erzeugte MR-Signal wird aufgenommen und zum Ermitteln des tatsächlichen Magnetfeldes verwendet. Dieses Vorgehen hat den Vorteil, dass neben dem vorhandenen MR-System keine weitere Ausrüstung benötigt wird. Jedoch ist der Zeitraum, in dem Gradienteneffekte gemessen werden können, durch die Querrelaxationszeit T2*, d.h. eine durch Spin-Spin-Wechselwirkung verursachte Dephasierung, begrenzt. Es hat sich gezeigt, dass diese Gradienteneffekte, insbesondere bei Langzeitgradienten wie sie z.B. in der Diffusionsgewichteten Magnetresonanztomographie verwendet werden, Wirbelstromeffekte mit einer Abklingzeit von mehreren hundert Millisekunden verursachen können, was deutlich länger als übliche T2* ist. Es können mit dieser Methode also nicht immer alle Effekte über ihren gesamten Zeitraum vollständig erfasst werden. Im Frequenzbereich bedeutet dies, dass nicht das komplette Frequenzspektrum abgedeckt ist bzw. es nur in geringerer Auflösung bestimmt werden kann.

Es ist daher Aufgabe der vorliegenden Erfindung, ein Verfahren bereitzustellen, mit dem eine Charakterisierungsfunktion für ein Gradientensystem einer Magnetresonanzanlage ermittelt und/oder angewandt werden kann, die möglichst den gesamten Zeitraum, in dem durch einen Gradientenpuls verursachte Effekte auftreten, erfasst bzw. die das damit verbundene Frequenzspektrum möglichst vollständig und hochaufgelöst wiedergibt, wobei möglichst wenige zusätzliche Komponenten benötigt werden sollen.

Dieses Problem wird gelöst durch ein Verfahren zum Erzeugen einer Charakterisierungsfunktion nach Anspruch 1, einer Magnetresonanzanlage nach Anspruch 13 und einem Datenträger nach Anspruch 14 und 15.

Gemäß einem Aspekt wird ein Verfahren zum Erzeugen einer Charakterisierungsfunktion für ein Gradientensystem einer Magnetresonanzanlage, insbesondere einer Übertragungsfunktion oder einer Impulsantwort zwischen einem nominellen Magnetfeld und einem tatsächlichen Magnetfeld vorgeschlagen, welches die folgenden Schritte umfasst:
- Hintereinander Ausführen zumindest zweier Testmessungen an einem in der Magnetresonanzanlage platzierten Objekt, insbesondere an einem Phantom, wobei jede Testmessung die folgenden Schritte aufweist:
   (a) Erzeugen eines Anregungspulses;
   (b) Auslesen eines MR-Signals während eines vorbestimmten Aufnahmezeitfensters nach dem Anregungspuls;
   (c) Erzeugen eines Testgradientenpulses gemäß einem nominellen Testgradientenpuls, mit einem für jede Testmessung vorbestimmten zeitlichen Versatz zwischen dem Zeitpunkt des Anregungspulses und dem Zeitpunkt des Testgradientenpulses,
   wobei sich der zeitliche Versatz zwischen dem Zeitpunkt des Anregungspulses und dem Zeitpunkt des Testgradientenpulses bei einer ersten Testmessung von dem zeitlichen Versatz bei einer zweiten Testmessung unterscheidet;
- Ermitteln des tatsächlichen Magnetfeldes des Testgradientenpulses durch Zusammenfügen und Auswerten der mit den Testmessungen ausgelesenen MR-Signale;
- Berechnen zumindest eines Terms der Charakterisierungsfunktion durch Vergleich des nominellen Magnetfeldes des Testgradientenpulses mit dem ermittelten tatsächlichen Magnetfeld.

Die in Spiegelstrichen gegebenen Schritte werden vorzugsweise in der gegebenen Reihenfolge ausgeführt. Ebenso werden die Schritte a) und b) der Testmessung vorzugsweise in der gegebenen Reihenfolge ausgeführt. Der Schritt c) einer Testmessung kann jedoch, insbesondere in Abhängigkeit des jeweiligen zeitlichen Versatzes vor, während, zwischen und/oder nach den Schritten a) und b) der jeweiligen Testmessung ausgeführt werden. Die Verfahrensschritte können beispielsweise durch eine Steuereinheit der Magnetresonanzanlage kontrolliert und/oder ausgelöst werden. Beispielsweise kann die Steuereinheit dazu konfiguriert sein, die Verfahrensschritte gemäß einer Voreinstellung, z.B. anhand eines Computerprogramms, auszuführen bzw. die Ausführung der Verfahrensschritte durch die Magnetresonanzanlage zu veranlassen. Es ist alternativ oder zusätzlich auch denkbar, dass die Verfahrensschritte teilweise oder vollständig manuell durch einen Nutzer durchgeführt und/oder veranlasst werden.

Das Gradientensystem kann insbesondere dazu konfiguriert sein, Gradientenfelder in drei Raumrichtungen, z.B. x-, y- und z-Achse, erzeugen zu können, wobei durch Überlagerung der Achsen grundsätzlich ein Magnetfeldgradient in jeder Richtung erzeugt werden kann. Ein Testgradientenpuls bezeichnet dabei insbesondere das Ausgeben eines Gradientenfelds in Form einer zeitabhängigen Funktion, die beispielsweise ausgehend von einem Startwert Null, d.h. kein Signal, einen endlichen, gegebenenfalls zeitlich variablen, Wert ausgibt und schließlich wieder zu dem Wert Null als Endwert zurückkehrt. In vorteilhaften Ausführungsformen wird bei dem Testgradientenpuls nur eine der Gradientenspulen angesteuert, sodass das nominelle Magnetfeld einen Gradienten in einer der drei senkrecht stehenden Raumrichtungen x, y, und z aufweist, dies ist jedoch nicht zwingend. Die Magnetresonanzanlage (MR-Anlage) kann neben dem Gradientensystem vorzugsweise noch eine Hauptspule zur Erzeugung eines Grundmagnetfeldes B₀, eine Hochfrequenzspule (HF-Spule), die insbesondere dazu ausgerichtet sein kann, die Anregungspulse zu erzeugen und/oder MR-Signale zu empfangen, und/oder einen Patiententisch umfassen. Der Anregungspuls kann beispielsweise durch die HF-Spule erzeugt werden und insbesondere ein HF-Puls sein. Der Anregungspuls kann verwendet werden, um das magnetische Moment der Atomkerne des Objekts bzw. Phantoms aus einer zu dem Grundmagnetfeld parallelen Orientierung herauszubewegen und dadurch in eine Präzessionsbewegung mit einer Larmorfrequenz zu versetzen. Die Präzessionsbewegung erzeugt eine Magnetisierung, die in zumindest einer Messspule, beispielsweise der Hochfrequenzspule und/oder zumindest einer eigens vorgesehenen Spule, eine Wechselspannung induziert, welche wiederum als MR-Signal ausgelesen werden kann. Das MR-Signal wird insbesondere durch den Testgradientenpuls bzw. das durch den Testgradientenpuls erzeugte Magnetfeld indirekt über das Objekt/Phantom beeinflusst bzw. verändert. Das Phantom kann beispielsweise ein dotiertes Wasser- oder Gelphantom sein.

Der Zweck der Charakterisierungsfunktion ist es insbesondere, den Unterschied zwischen dem nominellen Magnetfeld und dem tatsächlichen Magnetfeld, welches durch das Gradientensystem erzeugt wird, zu erfassen bzw. wiederzugeben. Das nominelle Magnetfeld kann dabei insbesondere auf einem bekannten Eingangssignal, mit dem das Gradientensystem angesteuert wird und das dazu konfiguriert ist ein bestimmtes Magnetfeld zu erzeugen, basieren. Das tatsächliche Magnetfeld kann sich hingegen von dem nominellen Magnetfeld unterscheiden, beispielsweise aufgrund von induzierten Wirbelströmen und/oder mechanischen Schwingungen der magnetfelderzeugenden Spulen. Die Charakterisierungsfunktion kann insbesondere dazu ausgelegt sein, das Übertragungsverhalten eines dynamischen Gradientensystems zu beschreiben. Die Charakterisierungsfunktion kann insbesondere eine Gradientenimpulsantwort (Englisch: gradient impulse response function, kurz GIRF) im Zeitbereich oder eine Übertragungsfunktion des Gradientensystems (Englisch: gradient system transfer function, kurz GSTF) im Frequenzbereich sein. Die beiden Funktionen lassen sich durch eine Fouriertransformation ineinander überführen. Die GIRF kann im Zeitbereich durch eine numerische Dekonvolution, d.h. die Umkehrung einer Faltungsoperation, bestimmt werden, oder allgemein indem ein lineares Gleichungssystem gelöst wird. In diesem linearen Gleichungssystem kann beispielsweise jede Zeile einem Zeitpunkt im gemessenen zeitlichen Verlauf des Magnetfeldes entsprechen. Insbesondere können in diesem Verfahren mehrere Testmessungen zur Berechnung der GIRF kombiniert werden, indem das lineare Gleichungssystem um entsprechende Zeilen erweitert wird. Die GSTF kann dagegen im Frequenzbereich beispielsweise dadurch bestimmt werden, dass die Fourier-Transformierte des zeitlichen Verlaufs des tatsächlichen Magnetfelds und/oder der Summe der tatsächlichen Magnetfelder durch die Fourier-Transformierte des nominellen zeitlichen Verlaufs des Testgradientenpulses und/oder der Summe der nominellen Testgradientenpulse dividiert wird.

Grundsätzlich können bei Anwenden des Gradientensystems Abweichungen des tatsächlichen vom nominellen Gradientenfeld in der Richtung des Gradientenpulses selbst erfolgen, also in der Raumrichtung, in der der angewandte Gradient selbst orientiert ist. Eine solche Abweichung kann in der Charakterisierungsfunktion mit einem Selbstterm 1. Ordnung, d.h. einem linearen Term in der Richtung des Gradientenpulses, berücksichtigt werden. Es können jedoch auch Effekte, d.h. insbesondere magnetische Feldabweichungen, in andere Raumrichtungen und/oder nicht-lineare Effekte auftreten. Beispielsweise kann durch das Schalten eines Gradientenpulses ein zusätzliches, räumlich konstantes Magnetfeld erzeugt werden. In anderen Worten, das Grundmagnetfeld B₀ kann beeinflusst bzw. verändert werden. Diesem Umstand kann mit einem Term 0. Ordnung Rechnung getragen werden. Eine Auswirkung des Gradientenpulses in eine Raumrichtung senkrecht zu der Raumrichtung des Gradientenpulses kann durch lineare Crossterme, d.h. Terme 1. Ordnung, die die Raumrichtung senkrecht zu dem Gradientenpuls betreffen, berücksichtigt werden. Schließlich können auch Terme 2. Ordnung, d.h. quadratische Terme, oder Terme noch höherer Ordnung für die jeweiligen Raumrichtungen erstellt werden. In vielen Fällen sind die linearen Streufelder in Richtung des Testgradienten am stärksten ausgeprägt. Es kann daher vorteilhaft sein, nur den linearen Selbstterm 1. Ordnung zu berechnen bzw. zu bestimmen. Zum Beispiel kann eine Gradientenimpulsantwort, welche Selbstterme verschiedener räumlicher Ordnungen beinhaltet, dazu geeignet sein, ein lineares, zeit-invariantes System vollständig oder annährend vollständig zu beschreiben. Beispielsweise können dadurch der Messaufwand bzw. der Rechenaufwand optimiert werden, wenn eine genauere Messung nicht benötigt wird, bzw. wenn der Einfluss anderer Terme in der verwendeten Konfiguration vernachlässigt werden kann. Andererseits kann es aber auch, beispielsweise aufgrund der durch die Konfiguration erzeugten Streufelder, vorteilhaft sein, andere und/oder weitere Terme zu bestimmen.

Grundsätzlich kann die zeitliche Reihenfolge, in der die Testmessungen durchgeführt werden, variabel sein. D.h., die erste Testmessung muss nicht notwendigerweise vor der zweiten Testmessung durchgeführt werden. Ebenso können sich die Testgradientenpulse, die Schichtpositionen oder sogar die Lokalisierungstechniken der Testmessungen unterscheiden. Alternativ ist es auch eine Option, dass der Testgradientenpuls für jede Testmessung gleich ist. Ein gleicher Testgradientenpuls für zwei oder mehr Testmessungen kann beispielsweise für die Berechnung im Frequenzbereich vorteilhaft und/oder notwendig sein. Durch den unterschiedlichen zeitlichen Versatz zwischen Anregungspuls und Testgradientenpuls bei zumindest zwei verschiedenen Testmessungen können vorteilhafterweise unterschiedliche Zeitbereiche während und nach dem Erzeugen des Testgradientenpulses ausgemessen werden. Dadurch kann das tatsächliche Magnetfeld nach dem Zusammenfügen und Auswerten der MR-Signale der Testmessungen vorteilhafterweise über einen insgesamt größeren Zeitbereich nach dem Einsetzen des Testgradienten ausgemessen werden, da ein einzelnes Aufnahmezeitfenster grundsätzlich durch die Dephasierungszeit T2* der Spins des Objekts begrenzt ist. Dies bedingt auch eine bessere Frequenzauflösung der GSTF. Insbesondere vorteilhaft kann dieses Verfahren sein, wenn MR-Sequenzen durch die Charakterisierungsfunktion korrigiert werden sollen, die besonders starke und/oder langanhaltende Gradienten vorsehen, wie zum Beispiel bei der Diffusionsgewichteten Bildgebung. Ein weiterer Vorteil kann sein, dass außer der ohnehin vorhandenen MR-Standardhardware keine oder kaum zusätzliche Komponenten benötigt werden. Des Weiteren kann vorteilhafterweise ein Standard-Phantom mit einer gewebeähnlichen T2*-Zeit verwendet werden, da selbst bei einer kurzen Abklingzeit T2* eine Bestimmung der Charakterisierungsfunktion über größere Zeiträume möglich ist. Dieses Verfahren kann damit insbesondere mit jedem oder nahezu jedem MR-System verwendet und relativ leicht mit einer entsprechenden Verfahrenssequenz implementiert werden.

Gemäß einer Ausführungsform liegt der Zeitpunkt des Testgradientenpulses bei einer ersten Testmessung im Anfangsbereich des Aufnahmezeitfensters der ersten Testmessung, wobei, relativ zum jeweiligen zugehörigen Testgradientenpuls, der Anregungspuls bei einer weiteren Testmessung später erzeugt wird als der Anregungspuls der ersten Testmessung. Die erste Testmessung muss dabei nicht notwendigerweise zeitlich vor der weiteren Testmessung stattfinden. Es kann aber eventuell für die weitere Auswertung vorteilhaft bzw. einfacher sein, die Testmessungen zeitlich entsprechend dem jeweiligen Versatz durchzuführen. Das spätere Erzeugen des Anregungspulses kann den Vorteil haben, dass Abweichungen des Magnetfeldes, z.B. aufgrund von induzierten Wirbelströmen, auch dann noch aufgenommen werden können, wenn das MR-Signal, bei einem früher erzeugten Anregungspuls, durch die begrenzte T2*-Zeitdauer bereits nicht mehr von einem Hintergrundrauschen unterscheidbar wäre. Insbesondere kann es vorgesehen sein, mehr als zwei Testmessungen zu verwenden, wobei der Anregungspuls jeweils zu verschiedenen relativen Zeitpunkten, also mit verschiedenem Zeitversatz zum Testgradientenpuls, erzeugt wird. Dies kann es beispielsweise ermöglichen, die Charakterisierungsfunktion für eine im Grunde beliebig große Zeitdauer zu messen, ohne durch die T2*-Zeit beschränkt zu sein.

Insbesondere kann es gemäß einer Ausführungsform vorgesehen sein, dass der Anregungspuls der ersten Testmessung vor dem zugehörigen Testgradientenpuls erzeugt wird und der Anregungspuls der zweiten Testmessung nach dem zugehörigen Testgradientenpuls erzeugt wird. Das kann insbesondere bedeuten, dass der zeitliche Versatz für die erste Testmessung negativ ist, während er für die zweite Testmessung positiv ist. Wenn der Anregungspuls im Rahmen der ersten Testmessung vor dem Testgradientenpuls liegt, insbesondere derart, dass der Erzeugungszeitpunkt des Testgradientenpulses in das Aufnahmezeitfenster fällt, können die Auswirkungen des Testgradienten von Anfang an bestimmt werden. Wird im Rahmen der zweiten Testmessung zuerst der Testgradientenpuls erzeugt und erst danach der Anregungspuls, so können auch Effekte, z.B. Wirbelstromeffekte, erfasst werden, die (deutlich) länger andauern als T2*.

Gemäß einer Ausführungsform ist ein Verfahren vorgesehen, wobei der Betrag der Differenz des ersten zeitlichen Versatzes und des zweiten zeitlichen Versatzes kleiner oder ungefähr gleich der Dauer des Aufnahmezeitfensters der ersten Testmessung ist. Auf diese Weise kann es ermöglicht werden, dass ein lückenloses Messen des MR-Signals durchgeführt wird.

Insbesondere kann gemäß einer Ausführungsform ein Verfahren vorgesehen sein, bei dem die Aufnahmezeitfenster der Testmessungen, jeweils relativ zu dem zugehörigen Testgradientenpuls, direkt nebeneinander liegende oder sich zu weniger als die Hälfte, bevorzugt weniger als ein Drittel und besonders bevorzugt maximal 10 Prozent, ihrer Dauer überlappende Zeitbereiche abdecken. In anderen Worten können zwei oder mehr Testmessungen einen Gesamtzeitbereich vollständig abdecken. Liegen die Zeitbereiche direkt nebeneinander, also ohne zeitlichen Abstand, so kann der Gesamtbereich lückenlos abgedeckt sein, wobei ohne Überlappung eine geringst mögliche Menge an Testmessungen benötigt wird. Eine lückenlose Anordnung der Zeitbereiche kann vorteilhaft für die numerische Auswertung der MR-Signale bzw. Bestimmung der Charakterisierungsfunktion sein. Es ist grundsätzlich auch denkbar, dass nebeneinanderliegende Zeitbereiche einen minimalen Abstand voneinander haben, insbesondere einen Abstand der für die Belange der Messung vernachlässigbar klein ist. Insbesondere kann es vorgesehen sein, dass zusätzlich zu der ersten und der zweiten Testmessung eine oder mehrere weitere Testmessungen durchgeführt werden, deren Aufnahmezeitfenster relativ zu dem zugehörigen Gradientenpuls untereinander und in Bezug zu den Aufnahmezeitfenstern der ersten und zweiten Testmessung in entsprechender Weise größtenteils unterschiedliche Zeitbereiche derart abdecken, dass durch Kombination der Aufnahmefenster der komplette relative zeitliche Bereich vom Zeitpunkt eines Gradientenpulses bis zum Ende des vom jeweiligen Gradientenpuls am weitesten entfernten Aufnahmezeitfensters abgedeckt ist. Es kann somit also ein sehr großer Zeitbereich durch mehrere Testmessungen lückenlos oder quasi lückenlos abgedeckt werden.

Gemäß einer Ausführungsform decken die Aufnahmezeitfenster insgesamt einen Bereich bis mindestens 50ms, vorzugsweise mindestens 100ms, nach dem Testgradientenpuls ab. In einer Ausführungsform reicht der durch die Aufnahmezeitfenster abgedeckte Zeitbereich maximal bis 500ms, vorzugsweise 350ms, insbesondere 250ms nach dem Testgradientenpuls. Die Länge der Zeitdauer des Bereichs kann insbesondere durch die erfindungsgemäßen unterschiedlichen Zeitversätze ermöglicht werden. Somit kann ein Bereich abgedeckt werden, der deutlich länger ist, als es ansonsten bei durch T2* begrenzten Verfahren nach dem Stand der Technik für übliche Messkonfigurationen in der Regel möglich ist.

Gemäß einer Ausführungsform ist ein Verfahren vorgesehen, wobei das tatsächliche, zeitabhängige Magnetfeld über eine zeitliche Ableitung der Phase des MR-Signals ermittelt wird, wobei insbesondere die gemessenen Phasen der verschiedenen Aufnahmezeitfenster im Anschluss an die Ableitung kombiniert werden. Die Geschwindigkeit der Präzessionsbewegung, d.h. die Larmorfrequenz, und damit auch das aufgenommene MR-Signal bzw. dessen Frequenz, in der Form eines in die Messspule induzierten Wechselstroms, hängt von dem Magnetfeld ab bzw. ist proportional zu diesem. Die Änderung des MR-Signals, d.h. die zeitliche Ableitung der Phase des Signals, kann daher verwendet werden, um das tatsächliche Magnetfeld zu ermitteln. Vorteilhafterweise können die mit verschiedenen Testmessungen ermittelten Magnetfelder anschließend kombiniert werden, um das tatsächliche Magnetfeld für einen größeren Zeitbereich zu ermitteln.

Gemäß einer Ausführungsform ist ein Verfahren vorgesehen, wobei die Charakterisierungsfunktion ermittelt wird, indem der zeitliche Verlauf des ermittelten tatsächlichen Magnetfelds sowie der nominelle zeitliche Verlauf des Testgradientenpulses Fourier-transformiert werden, wobei weiterhin die Fourier-Transformierte des zeitlichen Verlaufs des tatsächlichen Magnetfelds durch die Fourier-Transformierte des nominellen zeitlichen Verlaufs des Testgradientenpulses dividiert wird. Die Berechnung im Fourier-Raum, bzw. im Frequenzbereich, kann eine besonders einfache Möglichkeit darstellen, die Charakterisierungsfunktion, insbesondere in Form einer GSTF, zu berechnen, da sie beispielsweise mittels einer einfachen Division ermittelt werden kann. Bei Bedarf kann aus der GSTF beispielsweise die GIRF mittels einer inversen FourierTransformation berechnet werden. Alternativ ist es auch möglich die Charakterisierungsfunktion, insbesondere die GSTF, im Zeit-Bereich mittels einer numerischen Dekonvolution zu ermitteln, oder allgemein indem ein lineares Gleichungssystem gelöst wird.

Gemäß einer Ausführungsform ist ein Verfahren vorgesehen, wobei der Testgradientenpuls die Form eines Chirp-Signals oder eines Dreiecksignals hat. Während eine infinitesimal schmale Dirac-Delta-Funktion für das Verfahren ideal ist, da aufgrund ihrer Beschränkung im Zeitbereich eine quasi unendliche Frequenzbandbreite erreicht werden kann, ist eine perfekte Dirac-Delta-Funktion in der Regel keine Option für reale Gradientensysteme. Ein, insbesondere schmales, Dreieckssignal stellt daher eine gute Annäherung im Zeitbereich dar. Im Frequenzbereich wird das Dreieckssignal zu einer quadrierten Sinc-Funktion, deren Intensität von der Steigung des Dreieckssignals abhängt. Die Abstände der Nullstellen der sinc²-Funktion sind antiproportional zu der Länge des Dreiecksignals und die Nullstellen führen zu fehlenden Frequenzwerten bzw. zu einem begrenzten Frequenzbereich. Dieses Problem kann beispielsweise umgangen werden, indem mehrere Dreieckssignale unterschiedlicher Länge verwendet werden, die sich komplementär ergänzen. Alternativ und/oder additiv kann ein Chirp-Signal verwendet werden, also ein Signal mit sich ändernder Frequenz. Mit einem Chirp-Signal können insbesondere auch hohe Frequenzen erfasst werden. Im Fall der Verwendung mehrerer unterschiedlicher Eingangssignale für die Testgradientenpulse kann es notwendig sein, dass die gemessenen Daten in der Berechnung der Charakterisierungsfunktion kombiniert werden. Für die Bestimmung der GSTF im Frequenzbereich ist dies beispielsweise mittels der Methode der kleinsten Quadrate möglich. Für die Bestimmung der GIRF im Zeitbereich ist dies beispielsweise möglich, indem ein lineares Gleichungssystem gelöst wird, bei dem jede Zeile einem Zeitpunkt im gemessenen Verlauf des Magnetfeldes entspricht. Die Messungen der unterschiedlichen Testgradientenpulse können dann insbesondere als entsprechende Zeilen an das Gleichungssystem angefügt werden.

Gemäß einer Ausführungsform ist ein Verfahren vorgesehen, wobei eine Ortskodierung des MR-Signals in einer oder mehrerer Raumrichtungen durch Einschalten eines Schichtselektionsgradienten zum Zeitpunkt des Anregungspulses und/oder durch Einschalten eines oder mehrerer Phasenkodiergradienten zwischen dem Anregungspuls und dem Aufnahmezeitfenster erreicht wird. Die Ortskodierung nutzt dabei aus, dass die Larmorfrequenz von der Höhe des Magnetfelds abhängig ist. Für eine Schichtselektion kann daher ein Gradient angelegt werden, der eine lineare Variation des Magnetfelds in einer Richtung erzeugt. Der Anregungspuls kann dann mit einer bestimmten Frequenz, bzw. einem bestimmten Frequenzbereich, ausgegeben werden, die lediglich mit der Larmorfrequenz der Atome einer Schicht des Objekts übereinstimmt. Folglich werden nur Spins der Atome dieser Schicht ausgelenkt und nur diese Schicht trägt zum MR-Signal bei. Vorteilhafterweise wird eine Schicht ausgewählt, die nicht im Isozentrum des Gradientensystems liegt (eine Offcenter-Schicht), da diese (unter der Voraussetzung eines symmetrischen Gradientensystems) bereits die Bestimmung des linearen Selbstterms in Richtung des Schichtselektionsgradienten erlaubt. Gemäß einer Ausführungsform wird das gesamte Verfahren mit mehreren verschiedenen Ortskodierungen wiederholt, um das MR-Signal von mehreren Schichten zu bestimmen. In einer Ausführungsform werden für das Ermitteln von linearen Termen zumindest ein oder zwei verschiedene Schichten benötigt. Für das Ermitteln von höheren Termen können mehr als zwei Schichten benötigt werden. Alternativ ist es auch denkbar, dass mehrere Schichten simultan angeregt werden.

Gemäß einer Ausführungsform ist ein Verfahren vorgesehen, wobei die Verfahrensschritte des hierin beschriebenen Verfahrens mit verschiedenen Ortskodierungen des MR-Signals wiederholt werden, um mehrere Terme der Charakterisierungsfunktion zu ermitteln. Der Schichtselektionsgradient kann auf der gleichen Achse wie der Testgradientenpuls ausgeführt werden. In diesem Fall kann das in der jeweiligen Schicht gemessene Signal zum Bestimmen von Selbsttermen eingesetzt werden. Cross-Terme können dagegen ermittelt werden, indem der Schichtselektionsgradient auf einer anderen Achse als der Testgradientenpuls angelegt wird. Eine Ortskodierung kann alternativ auch mittels eines Phasenkodiergradienten erreicht werden. Dazu kann ebenfalls ausgenutzt werden, dass ein Magnetfeld die Larmorfrequenz beeinflusst. Entlang der Richtung eines magnetischen Gradienten kann sich daher die Larmorfrequenz der einzelnen Atome ortsabhängig unterscheiden bzw. einen linearen Verlauf haben. Dies kann insbesondere dazu führen, dass sich die Phase in Richtung des Phasenkodiergradienten, je nach Stärke und Dauer des Gradienten, unterschiedlich stark ändert. Es ist auch denkbar sowohl den Schichtselektionsgradienten als auch einen oder mehrere Phasenkodiergradienten zu verwenden. Damit kann z.B. eine Ortskodierung in zwei oder mehr verschiedene Raumrichtungen ermöglicht werden. Insbesondere können so Voxel ermittelt werden. Beispielsweise kann eine Phasenkodierung wie in J. Rahmer et al. Acquisition of the 3D MRI gradient impulse response function using a simple phantom measurement; Magn. Reson. Med. 2019; 82:2146-2159 verwendet werden.

Gemäß einer Ausführungsform ist ein Verfahren vorgesehen, wobei die Charakterisierungsfunktion lineare Selbstterme enthält, welche den Einfluss eines Gradientenpulses in einer Raumrichtung auf das lineare Gradientenfeld in derselben Raumrichtung beschreiben, und/oder lineare Crossterme enthält, welche den Einfluss eines Gradientenpulses in einer Raumrichtung auf das lineare Gradientenfeld in einer anderen Raumrichtung beschreiben. Gradientenpulse können generell nicht nur Abweichungen des tatsächlichen Magnetfeldes auf ihrer eigenen Achse, sondern auch auf Achsen, die senkrecht zu der jeweiligen Gradientenachse stehen, hervorrufen. Für jede dieser Abweichungen kann ein entsprechender Korrekturterm berechnet bzw. ermittelt werden. Selbstterme 1. Ordnung, d.h. lineare Terme, die die Achse des Gradientenpulses betreffen, können ermittelt werden, indem das tatsächliche Magnetfeld zum Beispiel an zumindest zwei Orten in Richtung des Gradienten ermittelt wird. Crossterme 1. Ordnung, d.h. lineare Terme, die eine Achse senkrecht zum Gradientenpuls betreffen, können ermittelt werden, indem das tatsächliche Magnetfeld zum Beispiel an zumindest zwei Orten in einer Richtung senkrecht zum Gradienten ermittelt wird. Unter der Annahme, dass die Gradientenfelder im Isozentrum 0 sind, kann es für die Bestimmung der Terme 1. Ordnung auch ausreichen, das tatsächliche Magnetfeld nur an einem Ort in der gewünschten Richtung zu ermitteln. Es kann z.B. je nach gewünschter Genauigkeit und Anfälligkeit des vorliegenden Systems für Verzerrungen entschieden werden, welche Terme zu bestimmen sind. Je nach der Konfiguration des Systems kann es auch hilfreich sein, Terme höherer Ordnungen zu bestimmen, wozu insbesondere weitere Messpunkte ermittelt werden können.

Gemäß einer Ausführungsform ist ein Verfahren vorgesehen wobei die Charakterisierungsfunktion zumindest einen Term 0ter Ordnung enthält, welcher den Einfluss eines Testgradientenpulses auf das räumlich konstante Magnetfeld beschreibt. Hiermit soll insbesondere ein durch den Gradienten verursachtes, räumlich konstantes Magnetfeld ermittelt werden. Ein konstantes Magnetfeld kann beispielsweise die Phase des gemessenen MR-Signals beeinflussen.

Gemäß einer Ausführungsform ist ein Verfahren vorgesehen, wobei vor dem Schritt des Zusammenfügens und Auswertens eine Referenzmessung durchgeführt wird, wobei im Rahmen der Referenzmessung die Testmessung unter Auslassung der Testgradientenpulse oder mit anderen Testgradientenpulsen, beispielsweise invertierten Testgradientenpulsen, ansonsten identisch wiederholt wird, wobei mittels der Referenzmessung die ausgelesenen MR-Signalphasen, insbesondere durch Subtraktion, korrigiert werden, sodass die verbleibenden Phasendaten im Wesentlichen nur auf den Einfluss der Testgradientenpulse zurückführbar sind. Ein invertierter Testgradientenpuls kann beispielsweise ein Dreieck mit invertierter Amplitude sein. Vorteilhafterweise kann durch Subtraktion der Signale der Referenzmessung der Effekt von Einflüssen, die nicht durch den Testgradientenpuls verursacht werden, herausgerechnet werden. Beispielsweise können so Effekte des Schichtselektionsgradienten und/oder des Phasenkodiergradienten negiert bzw. kompensiert werden. Damit kann letztlich insbesondere eine größere Genauigkeit der Charakterisierungsfunktion erreicht werden.

Ein weiterer Aspekt ist ein Verfahren zur Korrektur von Verzerrungen eines durch einen Testgradientenpuls verursachten nominellen Magnetfelds einer Magnetresonanzanlage mit einem Magnetfeldgradientensystem, umfassend:
- Erzeugen einer Charakterisierungsfunktion mit den Verfahrensschritten wie zuvor beschrieben;
- Verwendung der Charakterisierungsfunktion zum Ausgleich der Verzerrungen
durch Anpassen des nominellen Magnetfeldes über das Gradientensystem mittels der Charakterisierungsfunktion oder
durch Aufnehmen mindestens eines Magnetresonanzbilddatensatzes mit dem ursprünglichen nominellen Magnetfeld und nachträgliches Anpassen des Magnetresonanzbilddatensatzes mit Hilfe der Charakterisierungsfunktion. Alle Vorteile und Merkmale des Verfahrens zum Erzeugen einer Charakterisierungsfunktion gelten analog auch für das Verfahren zur Korrektur und umgekehrt. Beispielsweise kann der nominelle Gradient vorverzerrt werden, sodass der tatsächliche Gradient unter Einfluss der vorherrschenden Verzerrungen dem nominellen Gradienten entspricht. Mit anderen Worten kann die Charakterisierungsfunktion verwendet werden, um ein optimiertes Eingangssignal zu erzeugen, anhand dessen das gewünschte Ausgangssignal in Form des tatsächlichen Magnetfeldes erzeugt werden kann. Eine derartige Vorverzerrungstechnik kann auch als "Pre-Emphasis" bezeichnet werden. Eine Auswirkung des Gradientenpulses auf das konstante Hintergrundmagnetfeld kann beispielsweise durch Erzeugen eines entsprechenden Gegenmagnetfeldes durch eine zusätzliche Spule oder durch Verwenden einer vorhandenen geeigneten Spule ausgeglichen werden. Alternativ zu einem Vorverzerren kann das tatsächliche Magnetfeld mit Hilfe der Charakterisierungsfunktion anhand des nominellen Magnetfelds berechnet werden, was dann für Korrekturen während der Bildrekonstruktion verwendet werden kann.

Ein weiterer Aspekt ist eine Magnetresonanzanlage mit einem Magnetfeldgradientensystem umfassend eine Steuereinheit, die dazu konfiguriert ist, ein Verfahren wie hierin beschrieben auszuführen. Das Verfahren kann dabei insbesondere mittels der Steuereinheit, z.B. automatisch oder auf Nutzereingabe, kontrolliert werden. Beispielsweise kann die Steuereinheit dazu konfiguriert sein, auf ein Computerprogramm, welches auf einem Datenträger gespeichert ist und die entsprechenden Verfahrensschritte umfasst, zuzugreifen und die Verfahrensschritte entsprechend einzuleiten. Alle Vorteile und Merkmale des Verfahrens zum Erzeugen einer Charakterisierungsfunktion und des Verfahrens zur Korrektur gelten analog auch für die Magnetresonanzanlage und umgekehrt.

Ein weiterer Aspekt ist ein nichtflüchtiger Datenträger mit Programmcodeabschnitten, insbesondere für eine Steuereinheit einer Magnetresonanzanlage mit einem Magnetfeldgradientensystem, welcher Informationen und/oder Anweisungen zum Ausführen eines erfindungsgemäßen Verfahrens enthält, wobei die Programmcodeabschnitte die Magnetresonanzanlage mittels der Steuereinheit dazu veranlassen, das Verfahren nach wie hierin beschrieben auszuführen. Alle Vorteile und Merkmale des Verfahrens zum Erzeugen einer Charakterisierungsfunktion, des Verfahrens zur Korrektur und der Magnetresonanzanlage gelten analog auch für den Datenträger mit Programmcodeabschnitten und umgekehrt.

Ein weiterer Aspekt ist ein nichtflüchtiger Datenträger, insbesondere für eine Steuereinheit einer Magnetresonanzanlage mit einem Magnetfeldgradientensystem, welcher eine Charakterisierungsfunktion zur Anpassung eines nominellen Magnetfeldes mit einer Frequenzauflösung, die besser ist als 15 Hz, enthält, wobei die Charakterisierungsfunktion insbesondere durch ein Verfahren wie hierin beschrieben erzeugt wurde. Eine Charakterisierungsfunktion mit einer derartigen Frequenzauflösung kann mit üblichen experimentellen Bedingungen unter Ausnutzung von ausschließlich Standard MR-Komponenten in der Regel nicht erreicht werden. Sie kann jedoch durch das erfindungsgemäße Verfahren ermöglicht werden. Alle Vorteile und Merkmale des Verfahrens zum Erzeugen einer Charakterisierungsfunktion, des Verfahrens zur Korrektur, der Magnetresonanzanlage und des Datenträgers mit Programmcodeabschnitten gelten analog auch für den Datenträger mit der Charakterisierungsfunktion und umgekehrt.

Ein weiterer Aspekt ist ein Computerprogrammprodukt, umfassend Befehle, die bei Ausführung des Programms durch eine Steuereinheit einer Magnetresonanzanlage mit einem Magnetfeldgradientensystem, diese veranlassen die Schritte des Verfahrens wie hierin beschrieben auszuführen. Alle Vorteile und Merkmale des Verfahrens zum Erzeugen einer Charakterisierungsfunktion, des Verfahrens zur Korrektur, der Magnetresonanzanlage, des Datenträgers mit Programmcodeabschnitten und des Datenträgers mit der Charakterisierungsfunktion gelten analog auch für das Computerprogrammprodukt und umgekehrt.

Ein weiterer Aspekt ist eine Charakterisierungsfunktion zur Beschreibung und/oder zur Korrektur eines Unterschieds zwischen einem nominellen Magnetfeld und einem tatsächlichen Magnetfeld, welches durch ein Gradientensystem einer Magnetresonanzanlage erzeugt wird, mit einer Frequenzauflösung, die besser ist als 15Hz, wobei die Charakterisierungsfunktion insbesondere durch ein Verfahren wie hierin beschrieben erzeugt wurde. Alle Vorteile und Merkmale des Verfahrens zum Erzeugen einer Charakterisierungsfunktion, des Verfahrens zur Korrektur, der Magnetresonanzanlage, des Datenträgers mit Programmcodeabschnitten, des Datenträgers mit der Charakterisierungsfunktion und des Computerprogrammprodukts gelten analog auch für die Charakterisierungsfunktion und umgekehrt.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Es zeigen
- Fig. 1: eine Magnetresonanzanlage gemäß einer Ausführungsform der Erfindung,
- Fig. 2: den zeitlichen Verlauf zweier Testmessungen unter Verwendung eines Schichtselektionsgradienten, die für das Ermitteln einer Charakterisierungsfunktion verwendet werden können,
- Fig. 3: den zeitlichen Verlauf zweier Testmessungen unter Verwendung eines Phasenkodiergradienten, die für das Ermitteln einer Charakterisierungsfunktion verwendet werden können,
- Fig. 4: Messungen der frequenzabhängigen Größe des linearen GSTF-Selbstterms 1. Ordnung in z-Richtung,
- Fig. 5: Messungen der frequenzabhängigen Größe des GSTF-Cross-Terms 0. Ordnung zwischen dem z-Gradienten und dem konstanten Grundmagnetfeld, und
- Fig. 6: eine schematische Darstellung einer Ausführungsform eines erfindungsgemäßen Verfahrens.

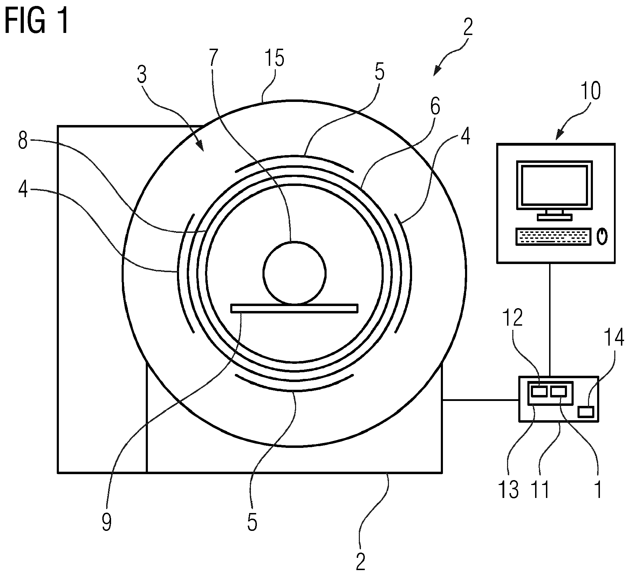

Fig. 1 zeigt eine Magnetresonanzanlage 2 mit einem Scanner 15, einer Steuereinrichtung 11, einer Patientenliege 9 und einem Benutzerinterface 10. Der Scanner 15 umfasst ein Gradientensystem 3 mit drei Gradientenspulen 4, 5 und 6, die dafür konfiguriert sind jeweils einen Magnetfeldgradienten in x-Richtung 4, y-Richtung 5 und z-Richtung 6 zu erzeugen. Durch Kombination der Gradientenspulen 4, 5 und 6 des Gradientensystems kann grundsätzlich ein Magnetfeldgradient in jeder Raumrichtung erzeugt werden. Der Scanner umfasst ferner eine Hochfrequenz (HF)-Spule 8 und eine Spule zur Erzeugung eines Hintergrundmagnetfeldes. Mit der HF-Spule 8 kann ein Anregungspuls zur Anregung eines sich in der Magnetresonanzanlage 2 befindlichen Objekts 7, z.B. eines Phantoms, erzeugt werden. Die HF-Spule 8 kann ebenfalls zum Empfang von MR-Signalen verwendet werden. Es ist alternativ aber auch möglich eine eigens für den Empfang vorgesehene, zusätzliche Empfangsspule zu verwenden, beispielsweise um das Signal-zu-Rausch-Verhältnis der empfangenen Signale zu optimieren. Die Steuereinrichtung 11 kann, wie hier gezeigt, außerhalb der Magnetresonanzanlage 2 angeordnet sein oder aber integraler Bestandteil der Magnetresonanzanlage 2 sein. Die Steuereinrichtung 11 umfasst einen Datenträger 13, auf dem ein Computerprogrammprodukt 12 gespeichert ist, welches einen Programmcode mit Verfahrensschritten enthält, um ein erfindungsgemäßes Verfahren auszuführen. Ferner ist auf dem Datenträger 13 eine Charakterisierungsfunktion 1 gespeichert, die mit dem erfindungsgemäßen Verfahren ermittelt wurde. Mittels dieser Charakterisierungsfunktion können Verzerrungen des Gradientenfeldes, die beispielsweise durch Wirbelströme hervorgerufen werden, ausgeglichen werden. Die Steuereinheit 11 ist mit einem Benutzerinterface 10 verbunden, von dem aus ein Benutzer Anweisungen geben und Einstellungen vornehmen kann. Zudem kann der Benutzer bei Bedarf das erfindungsgemäße Verfahren auch manuell über das Benutzerinterface 10 steuern.

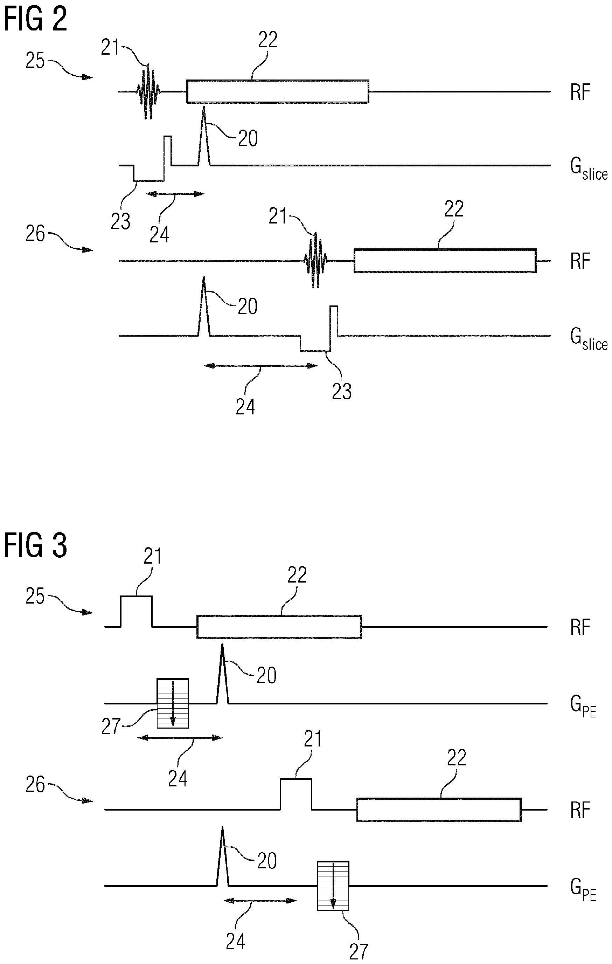

Fig. 2 zeigt den zeitlichen Verlauf zweier Testmessungen 25, 26, die für das Ermitteln der Charakterisierungsfunktion 1, z.B. einer GIRF oder einer GSTF, verwendet werden können, in Form eines Sequenzdiagramms. In der Fig. 2 sind die HF-Anregungspulse auf den mit RF gekennzeichneten Linien dargestellt, die Gradientenpulse auf den mit G_{slice} gekennzeichneten Linien. Während der ersten Testmessung 25 wird ein Anregungspuls 21 zusammen mit einem Schichtselektionsgradienten 23 ausgeführt, um das Testobjekt bzw. Phantom 7 anzuregen. Unmittelbar nach dem Anregungspuls 21 bzw. mit nur einem geringen zeitlichen Abstand startet das Aufnahmezeitfenster 22, in dem die MR-Signale, die durch das Phantom 7 erzeugt werden, ausgelesen werden. Die Länge des Aufnahmezeitfensters hängt von der T2*-Querrelaxationszeit ab. Durch ein Dephasieren der Spins nimmt das Signal mit der Zeit ab, sodass das Signal-zu-Rausch-Verhältnis immer geringer wird, bis schließlich kein Signal mehr ausgemacht werden kann, weshalb das Aufnahmezeitfenster 22 unweigerlich zeitlich begrenzt ist. Mit einem leichten zeitlichen Versatz 24 folgt nach dem Anregungspuls 21 der Testgradientenpuls 20. Insbesondere sein Einfluss auf das Magnetfeld kann über das aufgenommene MR-Signal ermittelt werden. Für die zweite Testmessung 26 werden der Anregungspuls 21, der Schichtselektionsgradient 23 und das Aufnahmezeitfenster 22 identisch ausgeführt, jedoch wird der Testgradientenpuls 20 in diesem Fall mit einem bestimmten (größeren) zeitlichen Versatz 24 bereits vor dem Anregungspuls 21 und damit auch vor dem Aufnahmezeitfenster 22 ausgeführt. Der Versatz 24 kann beispielsweise 10ms bis 100ms, insbesondere 30ms bis 80ms betragen. Magnetfeldeffekte, die direkt während und unmittelbar nach der Erzeugung des Testgradientenpulses 20 auftreten, werden in der zweiten Testmessung 26 nicht erfasst. Dafür können jedoch auch noch Effekte erfasst werden, die längere Zeit nach dem Erzeugen des Testgradientenpulses auftreten bzw. noch bestehen. Beispielsweise können durch den Testgradientenpuls verursachte Wirbelstromeffekte, die deutlich langsamer abklingen als die MR-Signalstärke, welche mit T2* abklingt, noch erfasst werden. Vorteilhafterweise schließen die Aufnahmezeitfenster 22 der beiden Testmessungen unmittelbar aneinander an bzw. haben eine leichte Überlappung, um sicherzustellen, dass das gesamte MR-Signal lückenlos erfasst werden kann. Ein Zusammenfügen der Messdaten der Aufnahmezeitfenster 22 ermöglicht es, insgesamt einen deutlich größeren Zeitbereich während und nach dem Erzeugen des Testgradientenpulses 20 abzudecken. Durch Hinzufügen weiterer Testmessungen, bei denen der Testgradientenpuls 20 mit einem entsprechend noch größeren zeitlichen Versatz 24 vor dem Anregungspuls 21 ausgeführt wird, können auch noch deutlich längere Gesamterfassungszeiten, insbesondere im Grunde beliebig lange Zeitbereiche, erreicht werden. Der Testgradientenpuls 20 hat in diesem Beispiel die Form eines Dreieckssignals. Es sind grundsätzlich jedoch auch andere Signalformen, beispielsweise ein Chirp-Signal oder eine Kombination aus mehreren Dreiecken, denkbar. In diesem Beispiel werden der Schichtselektionsgradient 23 und der Testgradientenpuls 20 auf der gleichen Gradientenachse erzeugt (z.B. der z-Achse). Durch Aufnehmen solcher Daten für zum Beispiel eine, zwei oder mehr verschiedene Schichten entlang der gleichen Achse wie der Testgradientenpuls 20, kann ein Selbstterm der Charakterisierungsfunktion ermittelt werden, d.h. die Auswirkungen des Testgradientenpulses 20 in einer Richtung parallel zu dem Testgradientenpuls 20. Befinden sich Testgradientenpuls 20 und Schichtselektionsgradient 23 auf verschiedenen Achsen (z.B. x-Achse und y-Achse), so können Cross-Terme ermittelt werden, sprich der Einfluss des Testgradientenpulses 20 auf eine der anderen Achsen.

Fig. 3 zeigt, analog zu der Darstellung in Fig. 2, den zeitlichen Verlauf zweier Testmessungen 25, 26, wobei diesmal statt des Schichtselektionsgradienten 23 ein Phasenkodiergradient 27 Anwendung findet. Der generelle zeitliche Verlauf entspricht demjenigen, der in Fig. 2 gezeigt ist, mit dem Unterschied, dass der Phasenkodiergradient 27 zwischen dem Anregungspuls 21 und dem Aufnahmezeitfenster 22 erzeugt wird, wodurch eine Dephasierung der Spins entlang des Gradienten erzeugt wird, mittels derer die MR-Signale ortskodiert werden können. Vorteilhafterweise können zusätzliche Referenzmessungen, bei denen der Testgradient 20 zum Beispiel ausgelassen oder invertiert wird, verwendet werden, um die Effekte, welche durch den Phasenkodiergradienten selbst erzeugt werden, zu kompensieren bzw. durch Subtraktion herausrechnen zu können.

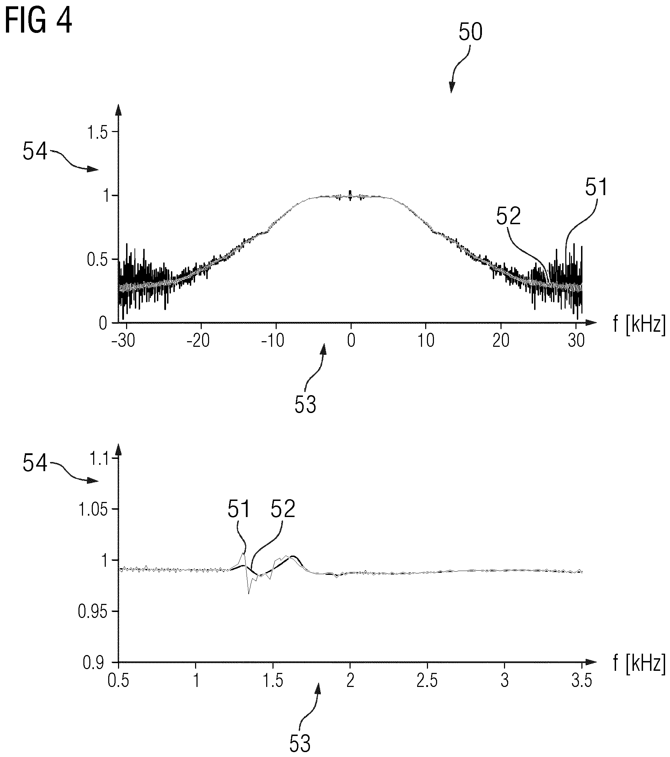

Fig. 4 zeigt die absolute Größe (Magnitude) 50 des linearen GSTF-Selbstterms in z-Richtung, d.h. des Selbstterms 1. Ordnung, aufgetragen gegen die Frequenz in kHz, mit zwei verschiedenen Frequenzauflösungen. Die Linie 52 zeigt die Größe des Selbstterms mit einer Auflösung von Δf=100,8Hz, gemessen mit einem Aufnahmezeitfenster von ca. 10ms gemäß dem Stand der Technik, und die Linie 51 zeigt die Größe des Selbstterms mit einer Auflösung von Δf=12,7Hz, gemessen über mehrere Aufnahmezeitfenster gemäß den mit diesem Verfahren aufgenommenen Daten 51. Eine bessere Frequenzauflösung (kleineres Δf) entspricht dabei einer längeren Messdauer im Zeitbereich, bzw. einer längeren Dauer der GIRF. Dabei ist auf der horizontalen Achse die Frequenz (in kHz) 53 und auf der vertikalen Achse die Größe des Selbstterms 54 aufgetragen. Der untere Plot zeigt einen vergrößerten Ausschnitt um den Resonanzbereich herum nahe bei einer Frequenz von 1,5 kHz. Es zeigt sich hier, dass die tatsächliche Resonanz (erkennbar bei einer Frequenzauflösung von Δf=12.7Hz 51) deutlich schmaler ist, als mit der niedrigeren Frequenzauflösung von Δf=100,8Hz 52 erkennbar wird. Dabei gilt insbesondere, dass eine schmalere Breite der Resonanz durch eine längere Abklingzeit der jeweiligen Wirbelstromeffekte verursacht wird. Die geringere Frequenzauflösung reicht in diesem Fall also nicht aus, um den Effekt der Wirbelströme vollständig wiederzugeben.

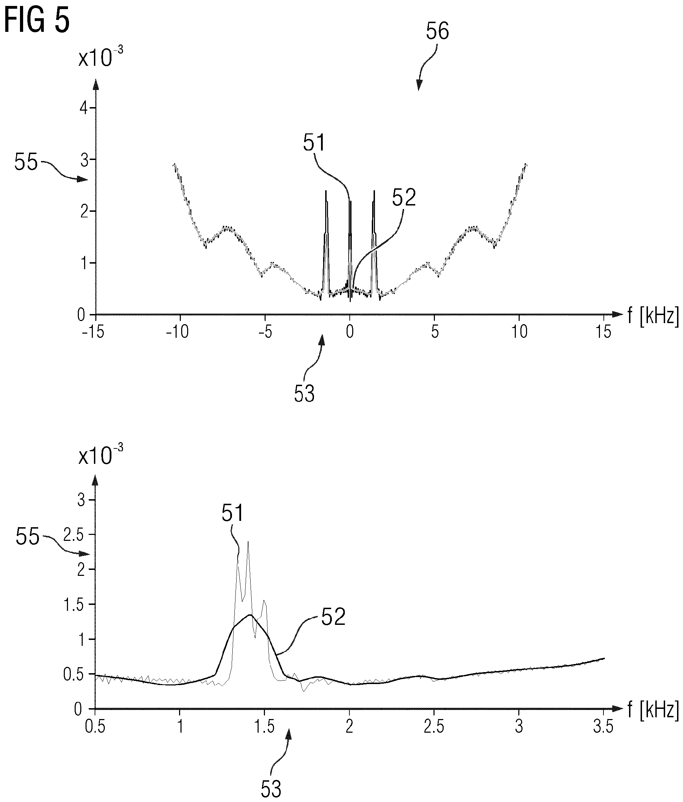

Fig. 5 zeigt Messungen der absoluten Größe 56 des GSTF-Cross-Terms 0. Ordnung zwischen einem Gradienten in z-Richtung und dem räumlich konstanten Grundmagnetfeld B0 mit zwei verschiedenen Frequenzauflösungen, nämlich Δf=100,8Hz, gemessen mit einem Aufnahmezeitfenster von ca. 10ms, gemäß dem Stand der Technik 52 und Δf=12,7Hz, gemessen über mehrere Aufnahmezeitfenster, gemäß den mit diesem Verfahren aufgenommenen Daten 51. Auch hier ist im unteren Plot eine vergrößerte Ansicht um den Resonanzbereich zwischen 1kHz und 2kHz gezeigt. Mit der besseren Frequenzauflösung 51 sind die Resonanzen ausgeprägter erkennbar und zudem etwas schmaler als durch die schlechtere Auflösung 52 suggeriert. Auch in diesem Fall kann mit der besseren Frequenzauflösung ein genaueres Ergebnis geliefert werden, während die schlechtere Frequenzauflösung zu einem verfälschten Ergebnis führt.

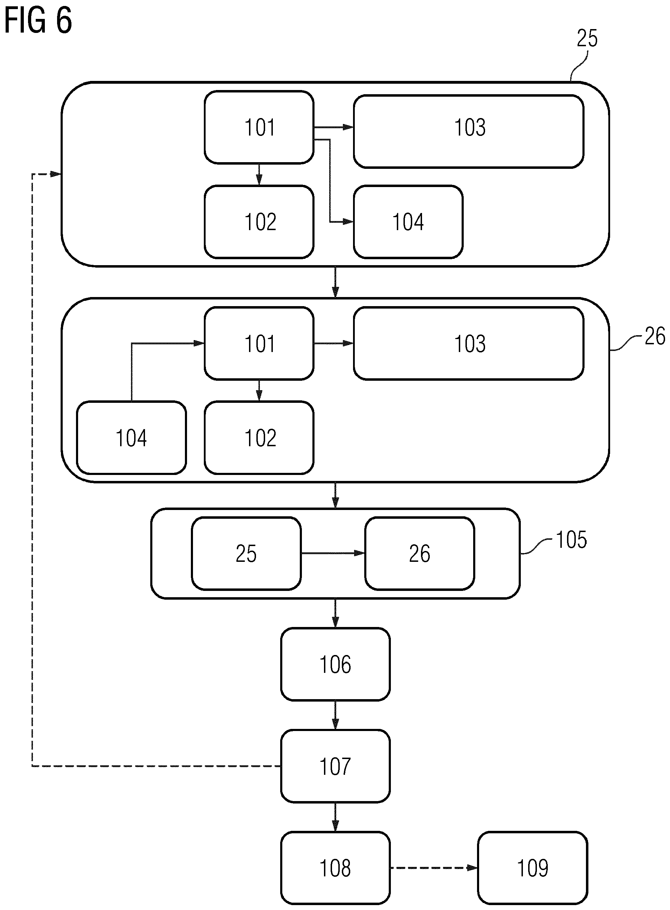

Fig. 6 zeigt eine schematische Darstellung eines Verfahrens zum Erzeugen einer Charakterisierungsfunktion. In diesem Ausführungsbeispiel werden zwei Testmessungen 25, 26 durchgeführt, es können jedoch auch mehr als zwei Testmessungen durchgeführt werden, um einen noch längeren Zeitbereich abzudecken. Während der ersten Testmessung 25 wird in einem ersten Schritt 101 zunächst ein Anregungspuls erzeugt. Gleichzeitig mit diesem ersten Schritt wird der Schritt einer Ortskodierung 102 durchgeführt, indem ein Schichtselektionsgradient erzeugt wird. Alternativ kann die Ortskodierung 102 auch in Form eines Phasenkodiergradienten nach dem Schritt 101 des Anregungspulses und vor dem nächsten Schritt 103, nämlich dem Auslesen des MR-Signals, durchgeführt werden. Der Schritt des Auslesens 103 wird dabei über den Zeitraum eines vorbestimmten Aufnahmezeitfensters hinweg durchgeführt. Zu Beginn des Aufnahmezeitfensters bzw. kurz nach dem Beginn erfolgt der Schritt zum Erzeugen eines Testgradientenpulses 104, wobei der Testgradientenpuls 20 gemäß einem nominellen Testgradientenpuls erzeugt wird, welcher beispielsweise die Form eines Dreiecksignals oder eines Chirp-Signals haben kann. Der erzeugte Testgradientenpuls 20 muss für die erste Testmessung 25 und die zweite Testmessung 26 nicht notwendigerweise gleich sein. Ein gleicher Testgradientenpuls 20 für beide Testmessungen 25, 26 kann aber beispielsweise für die Berechnung im Frequenzbereich vorteilhaft und/oder notwendig sein. Die zweite Testmessung 26 umfasst die gleichen Schritte wie die erste Testmessung 25. Sie unterscheidet sich jedoch von der ersten Testmessung im relativen Zeitpunkt des Schrittes zum Erzeugen eines Testgradientenpulses 104. Dieser erfolgt in der zweiten Testmessung 26 bereits, mit einem vorbestimmten zeitlichen Versatz, vor dem Erzeugen des Anregungspulses 101. Grundsätzlich können die erste Testmessung 25 und die zweite Testmessung 26 in beliebiger Reihenfolge zueinander ausgeführt werden. Wichtig ist insbesondere der unterschiedliche zeitliche Versatz zwischen Anregungspuls 101 und Testgradientenpuls 104. Das hier gezeigte Verfahren umfasst weiterhin den Schritt des Durchführens einer Referenzmessung 105. Hierfür werden die Testmessungen 25 und 26 wiederholt, mit dem Unterschied, dass diesmal jeweils der Schritt des Testgradientenpulses 104 ausgelassen wird oder durch einen geänderten Testgradientenpuls, beispielhaft einen invertierten Testgradientenpuls, ersetzt wird. Mittels des Ergebnisses der Referenzmessung 105 wird in einem folgenden Schritt 106 die Phase des aufgenommenen MR-Signals korrigiert, beispielhaft für einen ausgelassenen Testgradientenpuls in der Referenzmessung indem die MR-Signalphase der Referenzmessung von der MR-Signalphase der eigentlichen Messung (mit Testgradientenpuls) abgezogen wird. Damit kann sichergestellt werden, dass die verbleibenden MR-Phasendaten im Wesentlichen nur auf den Einfluss der Testgradientenpulse zurückführbar sind. In einem folgenden Schritt 107 kann dann das tatsächliche Magnetfeld ermittelt werden, indem die MR-Signalphasen der Testmessungen zusammengefügt werden. Dabei werden zunächst die tatsächlichen, zeitabhängigen Magnetfelder der Testmessungen 25, 26 über eine zeitliche Ableitung der Phase des MR-Signals ermittelt und anschließend zeitlich hintereinander kombiniert. An diesem Punkt können die bisherigen Verfahrensschritte mit unterschiedlichen Ortskodierungen 102 zumindest einmal wiederholt werden, um das Magnetfeld an mehreren Orten zu bestimmen. Dadurch können Terme 1. Ordnung oder Terme höherer Ordnungen bestimmt werden. Für einen linearen Term 1. Ordnung werden in einigen Ausführungsformen zumindest zwei Durchgänge mit zwei verschiedenen Ortskoordinaten benötigt. Für noch höhere Ordnungen können entsprechend noch weitere Durchgänge hinzugefügt werden. Insbesondere können auch Ortskodierungen in verschiedenen Richtungen verwendet werden, um sowohl Selbstterme als auch Cross-Terme ermitteln zu können. Schließlich erfolgt der Schritt des Berechnens der Charakterisierungsfunktion 108, bzw. zumindest eines Terms der Charakterisierungsfunktion durch Vergleich des nominellen Magnetfeldes des Testgradientenpulses mit dem ermittelten tatsächlichen Magnetfeld. Beispielsweise kann ein Term der Charakterisierungsfunktion ermittelt werden, indem der ermittelte zeitliche Verlauf des entsprechenden Terms des tatsächlichen Magnetfelds sowie der nominelle zeitliche Verlauf des Testgradientenpulses Fourier-transformiert werden und danach die Fourier-Transformierte des entsprechenden Terms des zeitlichen Verlaufs des tatsächlichen Magnetfelds durch die Fourier-Transformierte des nominellen zeitlichen Verlaufs des Testgradientenpulses dividiert wird. Für ein Verfahren zur Korrektur von Verzerrungen eines durch einen Gradientenpuls verursachten nominellen Magnetfelds kann anschließend noch die Ansteuerung des Gradientensystems mittels der Charakterisierungsfunktion durch eine Pre-emphasis 109 korrigiert werden. Alternativ kann auch ohne Anpassung des Gradientensystems eine Messung durchgeführt werden und der Magnetresonanzbilddatensatz nachträglich mit Hilfe der Charakterisierungsfunktion angepasst werden.

Obwohl die Erfindung im Detail durch die aufgeführten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Erzeugen einer Charakterisierungsfunktion (1) eines Gradientensystems einer Magnetresonanzanlage (2), insbesondere einer Übertragungsfunktion oder einer Impulsantwort zwischen einem nominellen Magnetfeld und einem tatsächlichen Magnetfeld, umfassend die Schritte:
- Hintereinander Ausführen zumindest zweier Testmessungen (25, 26) an einem in der Magnetresonanzanlage (2) platzierten Objekt (7), insbesondere an einem Phantom, wobei jede Testmessung (25, 26) die folgenden Schritte aufweist:
(a) Erzeugen eines Anregungspulses (21);
(b) Auslesen eines MR-Signals während eines vorbestimmten Aufnahmezeitfensters (22) nach dem Anregungspuls (21);
(c) Erzeugen eines Testgradientenpulses (20) gemäß einem nominellen Testgradientenpuls (20), mit einem für jede Testmessung (25, 26) vorbestimmten zeitlichen Versatz (24) zwischen dem Zeitpunkt des Anregungspulses (21) und dem Zeitpunkt des Testgradientenpulses (20),
wobei sich der zeitliche Versatz (24) zwischen dem Zeitpunkt des Anregungspulses (21) und dem Zeitpunkt des Testgradientenpulses (20) bei einer ersten Testmessung (25) von dem zeitlichen Versatz (24) bei einer zweiten Testmessung (26) unterscheidet;
- Ermitteln des tatsächlichen Magnetfeldes des Testgradientenpulses (20) durch Zusammenfügen und Auswerten der mit den Testmessungen (25, 26) ausgelesenen MR-Signale;
- Berechnen zumindest eines Terms der Charakterisierungsfunktion (1) durch Vergleich eines nominellen Magnetfeldes des Testgradientenpulses (20) mit dem ermittelten tatsächlichen Magnetfeld.

2. Verfahren nach Anspruch 1, wobei der Zeitpunkt des Testgradientenpulses (20) bei einer ersten Testmessung (25) im Anfangsbereich des Aufnahmezeitfensters (22) der ersten Testmessung (25) liegt, und wobei, relativ zum jeweiligen zugehörigen Testgradientenpuls (20), der Anregungspuls (21) bei einer weiteren Testmessung (26) später erzeugt wird als der Anregungspuls (21) der ersten Testmessung (25).

3. Verfahren nach einem der vorherigen Ansprüche, wobei der Anregungspuls (21) der ersten Testmessung (25) vor dem zugehörigen Testgradientenpuls (20) erzeugt wird und der Anregungspuls (21) der zweiten Testmessung (26) nach dem zugehörigen Testgradientenpuls (20) erzeugt wird.

4. Verfahren nach einem der vorherigen Ansprüche, wobei der Betrag der Differenz des ersten zeitlichen Versatzes (24) und des zweiten zeitlichen Versatzes (24) kleiner oder gleich der Dauer des Aufnahmezeitfensters (22) der ersten Testmessung (25) ist.

5. Verfahren nach einem der vorherigen Ansprüche, wobei die Aufnahmezeitfenster (22) der Testmessungen (25, 26), jeweils relativ zu dem zugehörigen Testgradientenpuls (20), direkt nebeneinander liegende oder sich zu weniger als die Hälfte ihrer Dauer überlappende Zeitbereiche abdecken.

6. Verfahren nach einem der vorherigen Ansprüche, wobei die Aufnahmezeitfenster (22) insgesamt einen Bereich bis mindestens 50ms, vorzugsweise mindestens 100ms, nach dem Testgradientenpuls (20) abdecken.

7. Verfahren nach einem der vorherigen Ansprüche, wobei das tatsächliche, zeitabhängige Magnetfeld über eine zeitliche Ableitung der Phase des MR-Signals ermittelt wird, wobei insbesondere die Magnetfelder der verschiedenen Aufnahmezeitfenster (22) im Anschluss an die Ableitung kombiniert werden.

8. Verfahren nach einem der vorherigen Ansprüche, wobei vor dem Schritt des Zusammenfügens und Auswertens eine Referenzmessung durchgeführt wird, wobei im Rahmen der Referenzmessung die Testmessung (25, 26) unter Auslassung der Testgradientenpulse (20) oder mit anderen Testgradientenpulsen (20), beispielsweise invertierten Testgradientenpulsen (20), ansonsten identisch wiederholt wird, wobei mittels der Referenzmessung die ausgelesenen MR-Signalphasen, insbesondere durch Subtraktion, korrigiert werden, sodass die verbleibenden Phasendaten nur auf den Einfluss der Testgradientenpulse (20) zurückführbar sind.

9. Verfahren nach einem der vorherigen Ansprüche, wobei eine Ortskodierung des MR-Signals in einer oder mehrerer Raumrichtung durch Einschalten eines Schichtselektionsgradienten (23) zum Zeitpunkt des Anregungspulses und/oder durch Einschalten eines oder mehrerer Phasenkodiergradienten (27) zwischen dem Anregungspuls und dem Aufnahmezeitfenster (22) erreicht wird.

10. Verfahren nach einem der vorherigen Ansprüche, wobei die Schritte gemäß Anspruch 1 mit verschiedenen Ortskodierungen des MR-Signals wiederholt werden, um mehrere Terme der Charakterisierungsfunktion (1) zu ermitteln.

11. Verfahren nach einem der vorherigen Ansprüche, wobei die Charakterisierungsfunktion (1) lineare Selbstterme enthält, welche den Einfluss eines Gradientenpulses in einer Raumrichtung auf das lineare Gradientenfeld in derselben Raumrichtung beschreiben, und/oder lineare Crossterme enthält, welche den Einfluss eines Gradientenpulses in einer Raumrichtung auf das lineare Gradientenfeld in einer anderen Raumrichtung beschreiben.

12. Verfahren nach einem der vorherigen Ansprüche, wobei die Charakterisierungsfunktion (1) zumindest einen Term 0ter Ordnung enthält, welcher den Einfluss eines Gradientenpulses auf das räumlich konstante Magnetfeld beschreibt.

13. Magnetresonanzanlage (2) mit einem Magnetfeldgradientensystem (3) umfassend eine Steuereinheit (11), die dazu konfiguriert ist, ein Verfahren nach einem der Ansprüche 1-12 auszuführen.

14. Nichtflüchtiger Datenträger (13) mit Programmcodeabschnitten, insbesondere für eine Steuereinheit (11) einer Magnetresonanzanlage (2) mit einem Magnetfeldgradientensystem (3), welcher Informationen und/oder Anweisungen zum Ausführen eines Verfahrens nach einem der Ansprüche 1-15 enthält, wobei die Programmcodeabschnitte die Magnetresonanzanlage (2) mittels der Steuereinheit (11) dazu veranlassen, das Verfahren nach einem der Ansprüche 1-12 auszuführen.

15. Nichtflüchtiger Datenträger (13), insbesondere für eine Steuereinheit (11) einer Magnetresonanzanlage (2) mit einem Magnetfeldgradientensystem (3), welcher eine Charakterisierungsfunktion (1) zur Anpassung eines nominellen Magnetfeldes mit einer Frequenzauflösung, die besser ist als 15 Hz, enthält, wobei die Charakterisierungsfunktion (1) insbesondere durch ein Verfahren nach einem der Ansprüche 1-12 erzeugt wurde.
